# EUROPEAN PATENT SPECIFICATION

(11) **EP 4 579 275 B1**
(45) Date of publication and mention of the grant of the patent: **21.10.2026**
(21) Application number: 24176181.6
(22) Date of filing: 16.05.2024
(51) Int. Cl.: G01S 7/481, G01S 7/4863, G01S 7/4865, G01S 17/89, G01S 17/931

(54) **LIDAR DEVICE AND METHOD OF OPERATING THE SAME**
LIDAR-VORRICHTUNG UND VERFAHREN ZUM BETRIEB DAVON
DISPOSITIF LIDAR ET SON PROCÉDÉ DE FONCTIONNEMENT

(30) Priority: 26.12.2023 KR 20230191418
(43) Date of publication of application: 02.07.2025
(73) Proprietor: Hyundai Mobis Co., Ltd., Gangnam-gu Seoul 06141 (KR)
(72) Inventor: YOON, Tae Won, 16891 Yongin-si (KR); KIM, Dong Uk, 16891 Yongin-si (KR)
(74) Representative: Vossius & Partner Patentanwälte Rechtsanwälte mbB

(56) References cited:
- EP-A1- 4 063 905
- EP-A1- 4 130 657
- US-A1- 2022 113 413
- US-B2- 10 801 886

## Description

### BACKGROUND

### FIELD

Exemplary embodiments of the present disclosure relate to a light detecting and ranging (LiDAR) device and a method of operating the same.

### DISCUSSION OF THE BACKGROUND

Recently, a light detecting and ranging (LiDAR) device has attracted much attention, along with an interest in autonomous driving vehicles and driverless vehicles. The LiDAR device uses a laser light signal to obtain information on distance to the surroundings. Thanks to advantages of having excellent precision and resolution and identifying an object in three-dimension, the LiDAR device is a trend being applied in various fields, such as drones, aircraft, and the like, as well as vehicles.

Conventionally, the entire array in a transceiver of the LiDAR device operates according to a pre-designated operation algorithm and in this case, a histogram method was used as a noise processing method. The histogram method is a method which accumulates multiple measurement values (interframes) to obtain single time-of-flight (ToF) result (one frame). Frames per second (fps) that denotes a speed of updating frames per second, is one of the main performance indicators of the LiDAR device.

According to the related art, as the resolution (the number of pixels) of a receiver increases, the region of the receiver that has to be covered by one pixel of a transmitter increases. Thus, there is a problem that the region of the receiver is wasted during operation due to the limited number of a readout integrated circuit (ROIC, one per column) including a time-to-digital converter (counter).

The related art of the present disclosure is disclosed in Korean Patent Application Publication No. 10-2023-0102817 (published on July 7, 2023 and entitled "LIDAR DEVICE AND OPERATING METHOD THEREOF").

EP 4 063 905 A1 discloses direct time-of-flight (DTOF) LiDAR system with smart laser interrogation, and a dToF/LiDAR receiver using SPAD pixels, TDC-based ToF processing, histogram generation, and intensity/ photon counting and it addresses receiver-side readout/processing architecture for obtaining ToF and intensity-related information from pixel outputs.

EP 4 130 657 A1 discloses a light reception device and distance measurement device.

US 10 801 886 B2 discloses a SPAC detector having modulated sensitivity.

### SUMMARY

Various embodiments are directed to providing a LiDAR device and a method of operating the same, which may obtain additional intensity data from wasted pixels in a receiver by utilizing a circuit (counter) used in a time-to-digital converter (TDC).

The object to be solved by the present disclosure is not limited to the above-mentioned object and other objects not mentioned herein will be clearly understood by those skilled in the art to which the present disclosure pertains from the following description. The invention is described by the content of the independent claims.

A LiDAR device according to an embodiment of the present invention comprises:a transmitter configured to transmit a laser light signal towards a target; and a receiver configured to receive a reflected laser light signal that is returned from being reflected by the target,wherein the receiver comprises a plurality of column circuits connected to sensors in the receiver through N, where N is a natural number equal to or greater than two, independent channels for each column of a pixel array corresponding to the sensors in the receiver,wherein when the sensors in the receiver are connected to two independent channels, a first channel and a second channel, the column circuit generates time-of-flight, ToF, histogram data for the corresponding pixel through the first channel and obtains the intensity data representing the number of times that the corresponding pixel has responded through the second channel.

The receiver may further include a sensor array module configured so that the sensors in the receiver have N times as many as sensors in the transmitter in each row for each column of the pixel array.

The column circuit may alternately operate the sensors in the receiver for each row of the pixel array based on a control signal sent through a column scanner to perform signal processing on a response of the sensor in the receiver to the reflected signal.

The column circuit may obtain the intensity data through a circuit configuration based on a single slope analog-to-digital converter (ADC).

The column circuit may include a switch and operate so that the sensor in the receiver and the first and the second channels may alternately be connected in units of frame through the switch.

The column circuit may further include a multiplexer (MUX) and a counter and share the counter with the first channel and the second channel through the multiplexer.

A method of operating a light detection and ranging (LiDAR) device according to an embodiment of the present disclosure includes transmitting, by a transmitter, a laser light signal towards a target, receiving, by a receiver, a reflected laser light signal that is returned from being reflected by the target, and performing signal processing, by the receiver, on a response of a sensor in the receiver to the reflected signal through a plurality of column circuits connected to sensors in the receiver, wherein the column circuits are connected to the sensors in the receiver through N (where N is a natural number equal to or greater than two) independent channels for each column of a pixel array corresponding to the sensors in the receiver.

The receiver may further include a sensor array module configured so that the sensors in the receiver have N times as many as sensors in the transmitter in each row for each column of the pixel array.

When the sensors in the receiver are connected to two independent channels, a first channel and a second channel, the column circuit generates time of flight (ToF) histogram data through the first channel and obtain intensity data representing the number of times that the corresponding pixel has responded through the second channel.

Details of other embodiments are included in the detailed description and the attached drawings of the present disclosure.

According to an embodiment of the present disclosure, the circuit (counter) used in TDC may be utilized to obtain additional intensity data from the pixels in the receiver, which allows the pixels in the receiver to be fully utilized to obtain outputs without wasted pixels.

According to an embodiment of the present disclosure, FPS may be improved by up to two times without reducing the performance of the LiDAR device.

### BRIEF DESCRIPTION OF THE DRAWINGS

FIG. 1 is a block diagram illustrating a light detection and ranging (LiDAR) device according to an embodiment of the present disclosure.
FIG. 2 is a diagram illustrating a detailed configuration of a receiver of FIG. 1.
FIG. 3 is a diagram illustrating a detailed configuration of a column circuit of FIG. 2.
FIGS. 4 and 5 are diagrams representing operation examples of the column circuit of FIG. 2.
FIG. 6 is a flowchart illustrating a method of operating the LiDAR device according to an embodiment of the present disclosure.

### DETAILED DESCRIPTION OF THE ILLUSTRATED EMBODIMENTS

The components described in the example embodiments may be implemented by hardware components including, for example, at least one digital signal processor (DSP), a processor, a controller, an application-specific integrated circuit (ASIC), a programmable logic element, such as an FPGA, other electronic devices, or combinations thereof. At least some of the functions or the processes described in the example embodiments may be implemented by software, and the software may be recorded on a recording medium. The components, the functions, and the processes described in the example embodiments may be implemented by a combination of hardware and software.

The method according to example embodiments may be embodied as a program that is executable by a computer, and may be implemented as various recording media such as a magnetic storage medium, an optical reading medium, and a digital storage medium.

Various techniques described herein may be implemented as digital electronic circuitry, or as computer hardware, firmware, software, or combinations thereof. The techniques may be implemented as a computer program product, i.e., a computer program tangibly embodied in an information carrier, e.g., in a machine-readable storage device (for example, a computer-readable medium) or in a propagated signal for processing by, or to control an operation of a data processing apparatus, e.g., a programmable processor, a computer, or multiple computers. A computer program(s) may be written in any form of a programming language, including compiled or interpreted languages and may be deployed in any form including a stand-alone program or a module, a component, a subroutine, or other units suitable for use in a computing environment. A computer program may be deployed to be executed on one computer or on multiple computers at one site or distributed across multiple sites and interconnected by a communication network.

Processors suitable for execution of a computer program include, by way of example, both general and special purpose microprocessors, and any one or more processors of any kind of digital computer. Generally, a processor will receive instructions and data from a read-only memory or a random access memory or both. Elements of a computer may include at least one processor to execute instructions and one or more memory devices to store instructions and data. Generally, a computer will also include or be coupled to receive data from, transfer data to, or perform both on one or more mass storage devices to store data, e.g., magnetic, magneto-optical disks, or optical disks. Examples of information carriers suitable for embodying computer program instructions and data include semiconductor memory devices, for example, magnetic media such as a hard disk, a floppy disk, and a magnetic tape, optical media such as a compact disk read only memory (CD-ROM), a digital video disk (DVD), etc. and magneto-optical media such as a floptical disk, and a read only memory (ROM), a random access memory (RAM), a flash memory, an erasable programmable ROM (EPROM), and an electrically erasable programmable ROM (EEPROM) and any other known computer readable medium. A processor and a memory may be supplemented by, or integrated into, a special purpose logic circuit.

The processor may run an operating system (OS) and one or more software applications that run on the OS. The processor device also may access, store, manipulate, process, and create data in response to execution of the software. For purpose of simplicity, the description of a processor device is used as singular; however, one skilled in the art will be appreciated that a processor device may include multiple processing elements and/or multiple types of processing elements. For example, a processor device may include multiple processors or a processor and a controller. In addition, different processing configurations are possible, such as parallel processors.

Also, non-transitory computer-readable media may be any available media that may be accessed by a computer, and may include both computer storage media and transmission media.

Features described in the specification in the context of individual example embodiments may be implemented as a combination in a single example embodiment. In contrast, various features described in the specification in the context of a single example embodiment may be implemented in multiple example embodiments individually or in an appropriate sub-combination.

Similarly, even though operations are described in a specific order on the drawings, it should not be understood as the operations needing to be performed in the specific order or in sequence to obtain desired results or as all the operations needing to be performed. In a specific case, multitasking and parallel processing may be advantageous. In addition, it should not be understood as requiring a separation of various apparatus components in the above described example embodiments in all example embodiments, and it should be understood that the above-described program components and apparatuses may be incorporated into a single software product or may be packaged in multiple software products.

It should be understood that the example embodiments disclosed herein are merely illustrative and are not intended to limit the scope of the invention. It will be apparent to one of ordinary skill in the art that various modifications of the example embodiments may be made without departing from the scope of the claims and their equivalents.

Hereinafter, with reference to the accompanying drawings, embodiments of the present disclosure will be described in detail so that a person skilled in the art can readily carry out the present disclosure. However, the present disclosure may be embodied in many different forms and is not limited to the embodiments described herein.

In the following description of the embodiments of the present disclosure, a detailed description of known functions and configurations incorporated herein will be omitted when it may make the subject matter of the present disclosure rather unclear. Parts not related to the description of the present disclosure in the drawings are omitted, and like parts are denoted by similar reference numerals.

In the present disclosure, components that are distinguished from each other are intended to clearly illustrate each feature. However, it does not necessarily mean that the components are separate. That is, a plurality of components may be integrated into one hardware or software unit, or a single component may be distributed into a plurality of hardware or software units.

In the present disclosure, components described in the various embodiments are not necessarily essential components, and some may be optional components.

Hereinafter, with reference to the accompanying drawings, embodiments of the present disclosure will be described in detail so that a person skilled in the art can readily carry out the present disclosure. However, the present disclosure may be embodied in many different forms and is not limited to the embodiments described herein.

In the following description of the embodiments of the present disclosure, a detailed description of known functions and configurations incorporated herein will be omitted when it may make the subject matter of the present disclosure rather unclear. Parts not related to the description of the present disclosure in the drawings are omitted, and like parts are denoted by similar reference numerals.

In the present disclosure, when a component is referred to as being "linked," "coupled," or "connected" to another component, it is understood that not only a direct connection relationship but also an indirect connection relationship through an intermediate component may also be included. In addition, when a component is referred to as "comprising" or "having" another component, it may mean further inclusion of another component not the exclusion thereof, unless explicitly described to the contrary.

In the present disclosure, the terms first, second, etc. are used only for the purpose of distinguishing one component from another, and do not limit the order or importance of components, etc., unless specifically stated otherwise. Thus, within the scope of this disclosure, a first component in one exemplary embodiment may be referred to as a second component in another embodiment, and similarly a second component in one exemplary embodiment may be referred to as a first component.

In the present disclosure, components that are distinguished from each other are intended to clearly illustrate each feature. However, it does not necessarily mean that the components are separate. That is, a plurality of components may be integrated into one hardware or software unit, or a single component may be distributed into a plurality of hardware or software units. Thus, unless otherwise noted, such integrated or distributed embodiments are also included within the scope of the present disclosure.

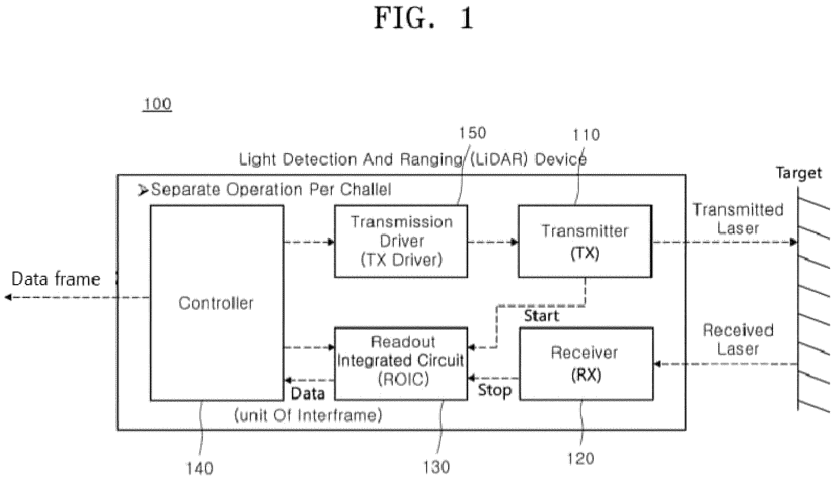

FIG. 1 is a block diagram illustrating a light detection and ranging (LiDAR) device according to an embodiment of the present disclosure.

Referring to FIG. 1, the LiDAR device 100 according to an embodiment of the present disclosure may be configured to include a transmitter 110, a receiver 120, a signal processor or a readout integrated circuit (ROIC) 130, a controller, and a transmission driver 150.

The transmitter 110 may transmit a laser light signal towards a target. To this end, the controller 140 may send a control command to the transmitter 150 through the transmission driver 150. At this time, the transmitter 110 may send a start signal indicating a time point at which the transmitter 110 begins to transmit a laser light signal towards the target, to the signal processor 130.

The receiver 120 may receive a reflected laser light signal that is returned from being reflected by the target. In this case, the receiver 120 may send a stop signal indicating a time point at which the receiver 120 completes to receive the reflected signal, to the signal processor 130.

The signal processor 130 may perform signal processing according to a control command of the controller 140. That is, the signal processor 130 may use the start signal and the stop signal so as to calculate the time elapsed between transmitting a laser light signal through the transmitter 110 and receiving, by the receiver 120, a reflected laser light signal reflected by the target, and then measure the distance to the target based on the calculated time.

To this end, conventionally, the entire array in the transmitter 110 and the receiver 120 operates according to a pre-designated operation algorithm upon receiving a command from the controller 140, wherein a histogram method was used as a noise processing method.

The histogram method is a method which accumulates multiple measurement values (interframes) to obtain single time-of- flight (ToF) result (one frame). For reference, frames per second (fps) that denotes the speed for updating frames per second, is one of the main performance indicators of the LiDAR device.

According to the related art, as the resolution (the number of pixels) of the receiver 120 increases, the region of the receiver 120 that has to be covered by one pixel of the transmitter 110 increases. Thus, there is a problem that the region of the receiver 120 is wasted during operation due to the limited number of a readout integrated circuit (ROIC, one per column) including a time-to-digital converter (counter).

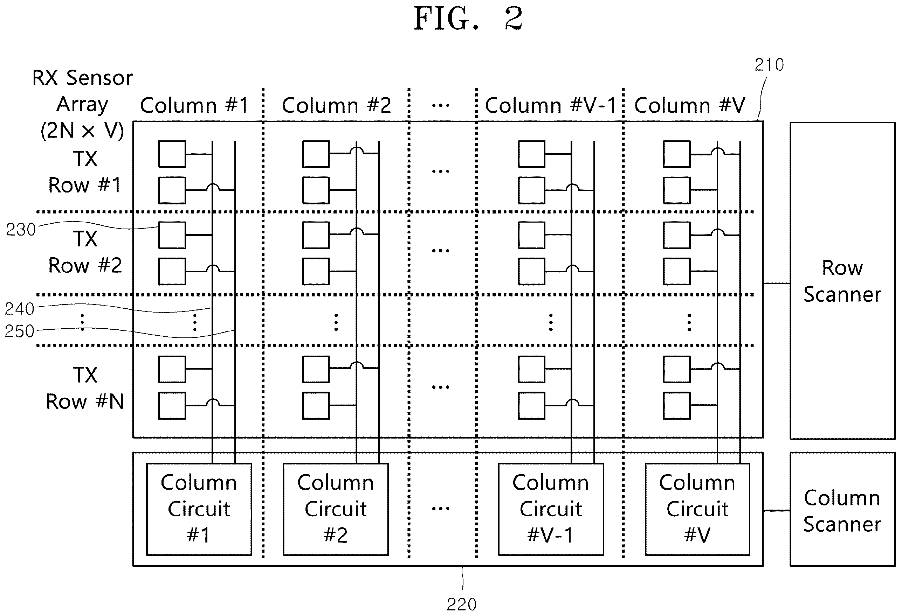

Accordingly, the receiver 120 may include a plurality of the column circuits 220 connected to sensors 230 in the receiver 120 through N (where N is a natural number equal to or greater than two) independent channels 240 and 250 for each column of a pixel array corresponding to the sensors 230 in the receiver 120 as illustrated in FIG. 2, thereby allowing the receiver 120 to obtain outputs without the wasted pixels.

The receiver 120 may further include a sensor array module 210 configured such that the sensors 230 in the receiver 120 have N times as many as sensors in the transmitter 110 in each row for each column of the pixel array.

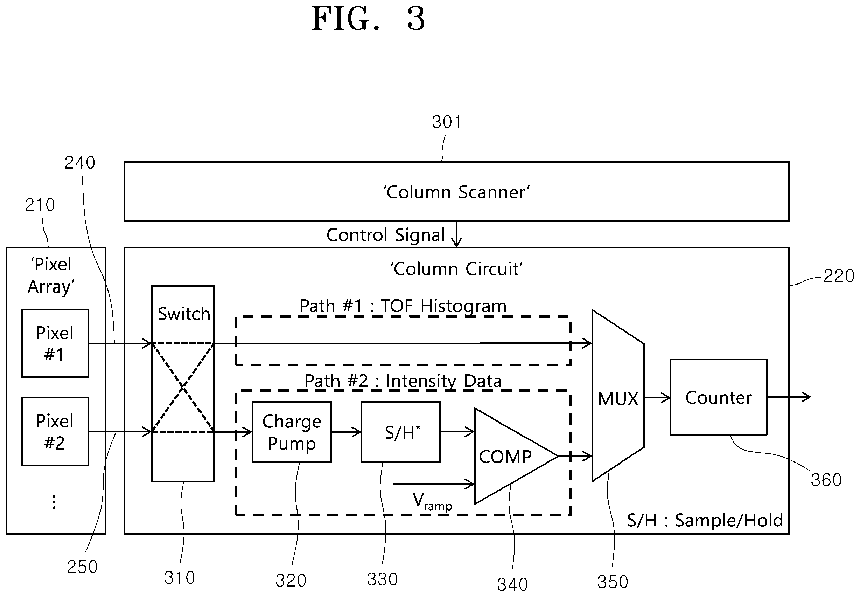

The column circuit 220 may alternately operate the sensors 230 in the receiver 120 for each row of the pixel array constituting the sensor array module, based on a control signal sent through a column scanner (see 301 in FIG. 3), and may perform signal processing on a response of the sensor 230 in the receiver 120 to the reflected signal.

For reference, the column scanner and a row scanner in FIG. 2 refer to circuits that enable to change channels according to a module operation algorithm.

Hereinafter, an embodiment of the present disclosure will be described on the assumption that the number of channels connected to each of the column circuits is two. It is obvious that this is only for easy of explanation and understanding, and is not intended to limit the scope of the present disclosure.

The sensors 230 in the receiver 120 may be connected to the column circuits 220 through the first channel 240 and the second channel 250. That is, the sensors 230 in the receiver 120 may be connected to the respective column circuits 220 through two independent channels, the first channel 240 and the second channel 250.

The column circuits 220 may generate time of flight (ToF) histogram data through the first channel 240 and obtain intensity data through the second channel 250. In this case, the intensity data may represent the number of times that the corresponding pixel has responded, which is the total number of data accumulated into a histogram.

To this end, the column circuit 220 may be configured to include a switch 310, a charge pump 320, a sample and hold amplifier (S/H: Sample/Hold) 330, a comparator 340, a multiplexer (MUX) 350, and a counter 360, as illustrated in FIG. 3.

The column circuits 220 may operate so that the sensors 230 in the receiver 120, and the first and the second channels 240 and 250 are alternately connected in units of frame through the switch 310.

When the first channel 240 is selected through the switch 310, the column circuit 220 may generate ToF histogram data for the corresponding pixel through the first channel 240.

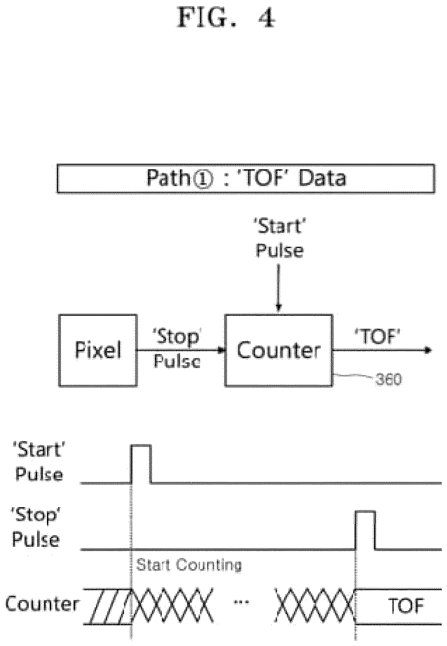

That is, as illustrated in FIG. 4, the column circuit 220 may begin counting at a start pulse and stop counting at a stop pulse on the first channel 240 by the counter 360 to which the start pulse and the stop pulse are input.

In this manner, the column circuit 220 may output ToF representing a time measurement value between the start pulse and the stop pulse, and then generate the ToF histogram data by accumulating the outputted ToF into the histogram.

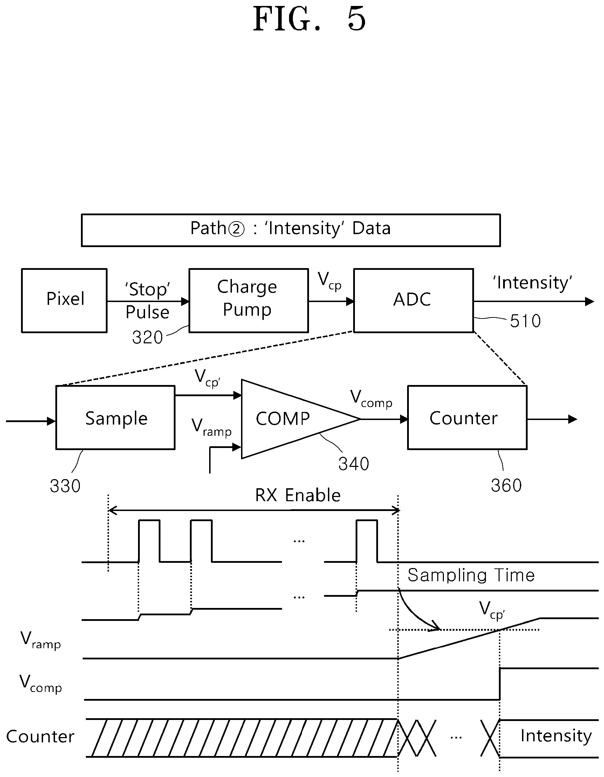

On the other hand, when the second channel 250 is selected through the switch 310, the column circuits 220 may generate the intensity data for the corresponding pixel through the second channel 250. That is, the column circuit 220 as illustrated in FIG. 5 may obtain the intensity data on the second channel 250 through a circuit configuration based on a single slope analog-to-digital converter (ADC) 510.

On the second channel, the charge pump 320 may receive a stop pulse input from the sensor 230 associated with the corresponding pixel and output a Vcp signal by accumulating the number of the stop pulses. In this case, the measurement cycle of the stop pulses may be implemented in unit of a row because it is necessary to accumulate the number of the stop pulses. The Vcp signal may represent the sum of several interframes.

When the charge pump 320 outputs the Vcp signal, the single slope ADC 510 may receive the Vcp signal and sample it through the S/H 330 to output a Vcp' signal that maintains a constant voltage. The single slope ADC 510 may receive the Vcp' signal and a Vramp signal through the comparator 340 and output a Vcomp signal when the two values, the Vcp' signal and the Vramp signal, become equal. The counter 360 may then receive the Vcomp signal output from the comparator 340 to obtain the intensity data.

The column circuit 220 may share the counter 360 with the first channel 240 and the second channel 250 through the multiplexer 350. That is, when the first channel 240 is selected through the switch 310, the column circuit 220 may open the first channel 240 to send ToF to the counter 360, and when the second channel 250 is selected through the switch 310, the column circuit 220 may open the second channel 250 to send the Vcomp signal to the counter 360.

Meanwhile, the present disclosure may also be applied even when the number of channels as described above is not RX : TX = 2 : 1, that is, two RX per one TX, but three or more RX per one TX. In such a case, FPS in another embodiment of the present disclosure may be improved using an interpolation method along with pixel operation switching (according to an embodiment of the present disclosure).

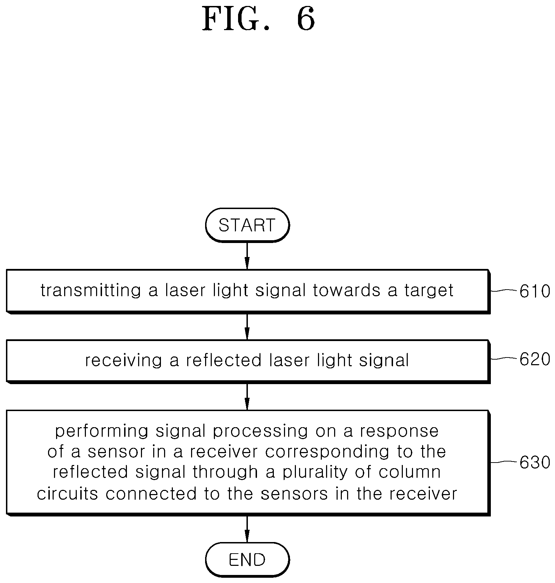

FIG. 6 is a flowchart illustrating a method of operating the LiDAR device, according to an embodiment of the present disclosure.

The method of operating the LiDAR device described herein is only one embodiment of the present disclosure, and various other steps such as the following steps, may be added as needed, and the following steps may be performed in a different order, so that the present disclosure is not limited to each of the steps and the order described below.

Referring to FIGS. 1, 2, and 6, in step 610, the transmitter 110 in the LiDAR device 100 may transmit a laser light signal towards a target.

Next, in step 620, the receiver 120 in the LiDAR device 100 may receive a reflected laser light signal that is returned from being reflected by the target.

Next, in step 630, the receiver 120 in the LiDAR device 100 may perform signal processing on a response of the sensor 230 in the receiver 120 to the reflected signal through a plurality of column circuits 220 connected to the sensors 230 in the receiver 120.

Here, each of the column circuits 220 may be connected to the sensors 230 in the receiver 120 through two independent channels 240 and 250 for each column of the pixel array corresponding to the sensors 230 in the receiver 120, such that a response of the sensor 230 in the receiver 120 to the reflected signal may be signal processed.

## Claims

1. A light detection and ranging, LiDAR, device, comprising:
a transmitter (110) configured to transmit a laser light signal towards a target; and
a receiver (120) configured to receive a reflected laser light signal that is returned from being reflected by the target,
wherein the receiver (120) comprises a plurality of column circuits (220) connected to sensors (230) in the receiver (120) through N, where N is a natural number equal to or greater than two, independent channels for each column of a pixel array corresponding to the sensors (230) in the receiver (120),
wherein when the sensors (230) in the receiver (120) are connected to two independent channels, a first channel (240) and a second channel (250), the column circuit (220) generates time-of-flight, ToF, histogram data for the corresponding pixel through the first channel (240) and obtains the intensity data representing the number of times that the corresponding pixel has responded through the second channel (250).

2. The LiDAR device (100) of claim 1,
wherein the receiver (120) further comprises a sensor array module (210) configured so that the sensors (230) in the receiver (120) have N times as many as sensors (230) in the transmitter (110) in each row for each column of the pixel array.

3. The LiDAR device (100) of claim 1, or 2,
wherein the column circuit (220) alternately operates the sensors (230) in the receiver (120) for each row of the pixel array based on a control signal sent through a column scanner to perform signal processing on a response of the sensor (230) in the receiver (120) to the reflected signal.

4. The LIDAR device (100) of any one of the preceding claims,
wherein the column circuit (220) obtains the intensity data through a circuit configuration based on a single slope analog-to-digital converter.

5. The LiDAR device (100) of any one of the preceding claims,
wherein the column circuit (220) comprises a switch (310) and operates so that the sensor (230) in the receiver (120) and the first and the second channels are alternately connected through the switch (310).

6. The LiDAR device (100) of claim 5,
wherein the column circuit (220) further comprises a multiplexer (350), MUX, and counter (360), and shares the counter (360) with the first channel (240) and the second channel through the multiplexer (350).

7. A method of operating a light detection and ranging, LiDAR, device, comprising:
transmitting, by a transmitter (110), a laser light signal towards a target;
receiving, by a receiver (120), a reflected laser light signal that is returned from being reflected by the target; and
performing signal processing, by the receiver (120), on a response of a sensor (230) in the receiver (120) to the reflected signal through a plurality of column circuits (220) connected to sensors (230) in the receiver (120);
wherein the column circuits (220) are connected to the sensors (230) in the receiver (120) through N, where N is a natural number equal to or greater than two, independent channels for each column of a pixel array corresponding to the sensors (230) in the receiver (120),
wherein when the sensors (230) in the receiver (120) are connected to two independent channels, a first channel (240) and a second channel, the column circuit (220) generates time of flight, ToF, histogram data for the corresponding pixel through the first channel (240) and obtains the intensity data representing the number of times that the corresponding pixel has responded through the second channel.

8. The method of claim 7,
wherein the receiver (120) comprises a sensor array module (210) configured so that the sensors (230) in the receiver (120) have N times as many as sensors (230) in the transmitter (110) in each row for each column of the pixel array.

## Patentansprüche

1. Light-Detection-and-Ranging-Vorrichtung, LiDAR-Vorrichtung, aufweisend:
einen Sender (110), der konfiguriert ist, um ein Laserlichtsignal in Richtung eines Ziels zu senden; und
einen Empfänger (120), der konfiguriert ist, um ein reflektiertes Laserlichtsignal zu empfangen, das von der Reflexion durch das Ziel zurückkehrt,
wobei der Empfänger (120) mehrere Spaltenschaltungen (220) aufweist, die mit Sensoren (230) in dem Empfänger (120) über N, wobei N eine natürliche Zahl gleich oder größer als zwei ist, unabhängige Kanäle für jede Spalte eines Pixelarrays, die den Sensoren (230) in dem Empfänger (120) entspricht, verbunden sind,
wobei, wenn die Sensoren (230) in dem Empfänger (120) mit zwei unabhängigen Kanälen, einem ersten Kanal (240) und einem zweiten Kanal (250), verbunden sind, die Spaltenschaltung (220) Laufzeit-, ToF-, Histogrammdaten, für das entsprechende Pixel über den ersten Kanal (240) erzeugt und die Intensitätsdaten, die die Häufigkeit darstellen, mit der das entsprechende Pixel reagiert hat, über den zweiten Kanal (250) erhält.

2. LiDAR-Vorrichtung (100) nach Anspruch 1,
wobei der Empfänger (120) ferner ein Sensorarraymodul (210) aufweist, das so konfiguriert ist, dass die Sensoren (230) in dem Empfänger (120) N-mal so viele wie Sensoren (230) in dem Sender (110) in jeder Zeile für jede Spalte des Pixelarrays vorweisen.

3. LiDAR-Vorrichtung (100) nach Anspruch 1 oder 2,
wobei die Spaltenschaltung (220) die Sensoren (230) in dem Empfänger (120) für jede Zeile des Pixelarrays basierend auf einem Steuersignal, das über einen Spaltenscanner übermittelt wird, abwechselnd betreibt, um eine Signalverarbeitung an einer Antwort des Sensors (230) in dem Empfänger (120) auf das reflektierte Signal durchzuführen.

4. LIDAR-Vorrichtung (100) nach einem der vorstehenden Ansprüche,
wobei die Spaltenschaltung (220) die Intensitätsdaten über eine Schaltungskonfiguration, die auf einem Single-Slope-Analog-Digital-Wandler basiert, erhält.

5. LiDAR-Vorrichtung (100) nach einem der vorstehenden Ansprüche,
wobei die Spaltenschaltung (220) einen Schalter (310) aufweist und so in Betrieb ist, dass der Sensor (230) in dem Empfänger (120) und der erste und der zweite Kanal über den Schalter (310) abwechselnd verbunden werden.

6. LiDAR-Vorrichtung (100) nach Anspruch 5,
wobei die Spaltenschaltung (220) ferner einen Multiplexer (350), MUX, und einen Zähler (360) aufweist und den Zähler (360) mit dem ersten Kanal (240) und dem zweiten Kanal über den Multiplexer (350) gemeinsam nutzt.

7. Verfahren zum Betreiben einer Light-Detection-and-Ranging-Vorrichtung, LiDAR-Vorrichtung, aufweisend:
Senden, durch einen Sender (110), eines Laserlichtsignals in Richtung eines Ziels;
Empfangen, durch einen Empfänger (120), eines reflektierten Laserlichtsignals, das von der Reflexion durch das Ziel zurückkehrt; und
Durchführen der Signalverarbeitung, durch den Empfänger (120), an einer Antwort eines Sensors (230) in dem Empfänger (120) auf das reflektierte Signal über mehrere Spaltenschaltungen (220), die mit Sensoren (230) in dem Empfänger (120) verbunden sind;
wobei die Spaltenschaltungen (220) mit den Sensoren (230) in dem Empfänger (120) über N, wobei N eine natürliche Zahl gleich oder größer als zwei ist, unabhängige Kanäle für jede Spalte eines Pixelarrays, die den Sensoren (230) in dem Empfänger (120) entspricht, verbunden sind,
wobei, wenn die Sensoren (230) in dem Empfänger (120) mit zwei unabhängigen Kanälen, einem ersten Kanal (240) und einem zweiten Kanal, verbunden sind, die Spaltenschaltung (220) Laufzeit-, ToF-, Histogrammdaten, für das entsprechende Pixel über den ersten Kanal (240) erzeugt und die Intensitätsdaten, die die Häufigkeit darstellen, mit der das entsprechende Pixel reagiert hat, über den zweiten Kanal erhält.

8. Verfahren nach Anspruch 7,
wobei der Empfänger (120) ein Sensorarraymodul (210) aufweist, das so konfiguriert ist, dass die Sensoren (230) in dem Empfänger (120) N-mal so viele wie Sensoren (230) in dem Sender (110) in jeder Zeile für jede Spalte des Pixelarrays vorweisen.

## Revendications

1. Dispositif de détection et télémétrie par ondes lumineuses, LiDAR, comprenant :
un émetteur (110) configuré pour émettre un signal de lumière laser vers une cible ; et
un récepteur (120) configuré pour recevoir un signal de lumière laser réfléchi qui est renvoyé après avoir été réfléchi par la cible,
dans lequel le récepteur (120) comprend une pluralité de circuits de colonnes (220) connectés à des capteurs (230) dans le récepteur (120) par l'intermédiaire de N, où N est un nombre naturel égal ou supérieur à deux, des canaux indépendants pour chaque colonne d'un réseau de pixels correspondant aux capteurs (230) dans le récepteur (120),
dans lequel, lorsque les capteurs (230) dans le récepteur (120) sont connectés à deux canaux indépendants, un premier canal (240) et un second canal (250), le circuit de colonne (220) génère des données d'histogramme de temps de vol, ToF, pour le pixel correspondant par l'intermédiaire du premier canal (240) et obtient les données d'intensité représentant le nombre de fois où le pixel correspondant a répondu par l'intermédiaire du second canal (250).

2. Dispositif LiDAR (100) selon la revendication 1,
dans lequel le récepteur (120) comprend en outre un module de réseau de capteurs (210) configuré de sorte que les capteurs (230) dans le récepteur (120) ont N fois plus de capteurs (230) que dans l'émetteur (110) dans chaque rangée pour chaque colonne du réseau de pixels.

3. Dispositif LiDAR (100) selon la revendication 1 ou 2,
dans lequel le circuit de colonne (220) fait fonctionner alternativement les capteurs (230) dans le récepteur (120) pour chaque rangée du réseau de pixels sur la base d'un signal de commande envoyé par l'intermédiaire d'un dispositif de balayage de colonne pour réaliser un traitement de signal sur une réponse du capteur (230) dans le récepteur (120) au signal réfléchi.

4. Dispositif LIDAR (100) selon l'une quelconque des revendications précédentes,
dans lequel le circuit de colonne (220) obtient les données d'intensité par l'intermédiaire d'une configuration de circuit basée sur un convertisseur analogique-numérique à pente unique.

5. Dispositif LiDAR (100) selon l'une quelconque des revendications précédentes,
dans lequel le circuit de colonne (220) comprend un commutateur (310) et fonctionne de sorte que le capteur (230) dans le récepteur (120) et le premier et le second canal sont connectés alternativement par l'intermédiaire du commutateur (310).

6. Dispositif LiDAR (100) selon la revendication 5,
dans lequel le circuit de colonne (220) comprend en outre un multiplexeur (350), MUX, et un compteur (360), et partage le compteur (360) avec le premier canal (240) et le second canal par l'intermédiaire du multiplexeur (350).

7. Procédé de fonctionnement d'un dispositif de détection et télémétrie par ondes lumineuses, LiDAR, comprenant :
l'émission, par un émetteur (110), d'un signal de lumière laser vers une cible ;
la réception, par un récepteur (120), d'un signal de lumière laser réfléchi qui est renvoyé après avoir été réfléchi par la cible ; et
la réalisation d'un traitement de signal, par le récepteur (120), sur une réponse d'un capteur (230) dans le récepteur (120) au signal réfléchi par l'intermédiaire d'une pluralité de circuits de colonnes (220) connectés à des capteurs (230) dans le récepteur (120) ;
dans lequel les circuits de colonnes (220) sont connectés aux capteurs (230) dans le récepteur (120) par l'intermédiaire de N, où N est un nombre naturel égal ou supérieur à deux, des canaux indépendants pour chaque colonne d'un réseau de pixels correspondant aux capteurs (230) dans le récepteur (120),
dans lequel, lorsque les capteurs (230) dans le récepteur (120) sont connectés à deux canaux indépendants, un premier canal (240) et un second canal, le circuit de colonne (220) génère des données d'histogramme de temps de vol, ToF, pour le pixel correspondant par l'intermédiaire du premier canal (240) et obtient les données d'intensité représentant le nombre de fois où le pixel correspondant a répondu par l'intermédiaire du second canal.

8. Procédé selon la revendication 7,
dans lequel le récepteur (120) comprend un module de réseau de capteurs (210) configuré de sorte que les capteurs (230) dans le récepteur (120) ont N fois plus de capteurs (230) que dans l'émetteur (110) dans chaque rangée pour chaque colonne du réseau de pixels.
